# EUROPEAN PATENT APPLICATION

(11) **EP 1 801 859 A1**
(43) Date of publication of application: **27.06.2007**
(21) Application number: 05788379.5
(22) Date of filing: 29.09.2005
(51) Int. Cl.: H01L 21/304, H01L 21/02, H01L 27/12

(54) **SOI WAFER CLEANING METHOD**

(30) Priority: 30.09.2004 JP 2004288165
(71) Applicant: SHIN-ETSU HANDOTAI COMPANY LIMITED, Chiyoda-ku Tokyo 100-0005 (JP)
(72) Inventor: MUNAKATA, Hideki c/o Shin-Etsu Handotai Co., Ltd., Nishikawa-gun Fukushima, 9618061 (JP)
(74) Representative: Wibbelmann, Jobst
(86) International application number: PCT/JP2005/017935
(87) International publication number: WO 2006/035864

(57) **Abstract**

A method for cleaning an SOI wafer having a silicon thin film on an insulator, wherein the SOI wafer is subjected to two-fluid cleaning in which two or more fluids are mixed and used for cleaning the wafer. Thereby, there is provided a method for cleaning an SOI wafer that sufficiently reduces impurity etc. adhered to the surface of the SOI wafer with inhibiting a decrease of film thickness and deterioration of haze level of the SOI layer of the SOI wafer as much as possible.

## Description

### Technical Field

The present invention relates to a method for cleaning an SOI wafer.

### Background Art

In conventional manufacturing of a semiconductor silicon wafer, the following steps are conducted: a slicing step for slicing a silicon single crystal ingot manufactured by a single crystal manufacturing apparatus to obtain a thin disc-like wafer; a chamfering step for chamfering the peripheral edge portion of the wafer obtained in the slicing step in order to prevent cracking or chipping of the wafer; a lapping step for lapping the chamfered wafer, thereby flattening the wafer; an etching step for removing process damage remained on the surface of the chamfered and lapped wafer; a primary polishing step for conducting rough polishing by rubbing the etched surface of the wafer with a polishing cloth mainly for the purpose of improving flatness of the wafer; a finish polishing step conducted mainly for the purpose of reducing surface roughness having a wavelength of from a few to several tens of nm, which is the so-called haze, on the surface of the primary-polished wafer; and final cleaning step for cleaning the finish-polished wafer to remove polishing agent or foreign matters which adhered to the wafer.

In the final cleaning step, the RCA cleaning espoused by Kern et al. is generally conducted. The RCA cleaning is mainly composed of SC-1 cleaning, cleaning with hydrofluoric acid, and SC-2 cleaning. In the RCA cleaning (For example, see Japanese Unexamined Patent Application Publication No. 2001-244260), firstly, a cleaning treatment (SC-1 cleaning) is conducted at a temperature of 75 to 85 degrees C for 10 to 20 minutes with a cleaning solution, which is referred to as SC-1 cleaning solution or Ammonia-Hydrogen Peroxide Mixture (APM solution), containing ammonia, hydrogen peroxide, and water in the blending volume ratio of 1 : 1 to 2 : 5 to 7 to remove organic substances and particles. Then a cleaning treatment (HF cleaning) is conducted at room temperature for several tens of seconds with 1% aqueous solution of hydrofluoric acid (a diluent, Diluted Hydrofluoric acid (DHF solution)) to remove metallic impurity along with natural oxide. Lastly, a cleaning treatment (SC-2 cleaning) is conducted at a temperature of 75 to 85 degrees C for 10 to 20 minutes with a cleaning solution, which is referred to as SC-2 cleaning solution or Hydrochloric acid-Hydrogen Peroxide Mixture (HPM solution), containing hydrochloric acid, hydrogen peroxide, and water in the blending volume ratio of 1 : 1 to 2 : 6 to 8 to remove metal adhered to silicon and to form a clean natural oxide.

After the above-mentioned steps are conducted to manufacture a several hundreds µm thick silicon wafer, and such a wafer is used to fabricate conventional semiconductor devices. But only the portion of 1 µm or less from the surface functions as a semiconductor device, and other portions just work as a support substrate. Current passes through these redundant portions uselessly, and which hampers reduction of electrical power consumption and increase of processing speed.

Then an SOI wafer (Silicon-on-insulator) has received attention as one of the next-generation semiconductor techniques in recent years. The SOI wafer realizes high speed and low electrical power consumption by providing an insulator layer between a semiconductor device and a support substrate thereby isolating influence from the support substrate. As an example of a method for manufacturing such an SOI wafer, such a method is known: a bond wafer and a base wafer both of which are made of single crystal silicon are prepared, the bond wafer is to be an SOI layer when the SOI wafer is formed, and the base wafer is to be a support of the SOI layer when the SOI wafer is formed; the bond wafer is subjected to thermal oxidation (BOX oxidation) to form an SiO₂ film; the bond wafer is superposed directly on the base wafer, and the wafers are subjected to a heat treatment in an oxidizing atmosphere to bond the wafers each other via the SiO₂ film; subsequently the bond wafer is processed into a thin film and thus an SOI layer by thinning the bond wafer to have a desired film thickness.

As another method for thinning the bond wafer, the following smart cut method (trade name) is commonly known. In this method, ions of hydrogen or a rare gas are implanted to the bonding surface (referred to as a primary surface) of the bond wafer so that an ion-implanted layer (a micro bubble layer) is formed at a given depth; and after the wafers are bonded, the bond wafer is delaminated at the ion-implanted layer. However, an SOI wafer obtained after the delamination has a damaged layer on the surface of an SOI layer due to the ion implantation, and roughness of the delaminated surface itself is larger than that of the mirror surface of a silicon wafer with normal product quality. In order to remove the damaged layer, the delaminated surface of the SOI layer is processed into a mirror surface by mirror-polishing with a small stock removal (normally called touch polish, and mechanical and chemical polishing is used).

As an other method for manufacturing an SOI wafer, a technique called SIMOX is used. In this method, oxygen ions are implanted into a silicon wafer to form an oxygen-ion-implanted layer; then this wafer is heated, and this heat treatment effects reaction between silicon in the wafer and oxygen ions in the oxygen-ion-implanted layer to form a buried insulator film.

Thus manufactured SOI wafers are subjected to a cleaning step finally and are delivered as products to device makers. In the cleaning step, the RCA cleaning is generally used up to now. The chemical solutions used in the RCA cleaning have an etching action against silicon, and thus the cleaning thins the SOI layer to some degree.

As for the SOI layer, a thinner film has been increasingly used in recent years, and thus SOI wafers each having an SOI layer of the order of several tens of nm have come to be used. In rigorous standards, thickness of such ultra thin film shall fall within ± 1 nm error. In general, in order to remove particles, it is recognized that about 4 nm or more of the SOI layer have to be etched by the RCA cleaning (For example, see Cleaning and analysis of silicon wafers, p.55 to p.58, issued by Realize Limited). This causes a problem that SOI wafers under such rigorous standards become out of spec of SOI layer film thickness. Furthermore, the etching causes a problem to deteriorate surface roughness having a wavelength of from a few to several tens of nm, which is the so-called haze, on the surface of the SOI layer.

Incidentally, mechanical cleaning that uses only pure water and does not use a chemical solution such as brush cleaning or ultrasonic cleaning cannot sufficiently remove contaminants on the surface of SOI wafers though the mechanical cleaning does not change SOI layer thickness because this cleaning does not have an etching action.

Furthermore, in the case of manufacturing SOI wafers, SOI wafers more than user demands are generally manufactured at a time in consideration of productivity. Accordingly, SOI wafers that are manufactured excessively are stored as stocks until SOI wafers having the same spec are demanded. In this case, when the wafers are stored for a long time, the wafers are cleaned again prior to delivery for the purpose of removing contaminants adhered to the surfaces of the wafers during storage. However, as described above, SOI wafers having an ultra thin film cannot be cleaned properly by RCA cleaning, brush cleaning or ultrasonic cleaning. In particular, RCA cleaning causes a problem that an ultra thin SOI layer becomes out of spec of thickness, and thus wafers cannot be delivered substantially as products. Therefore, SOI wafers having an ultra thin film cannot be stored after being manufactured, and no stocks should be carried by always manufacturing the same amount of products as demanded. Furthermore, delivery time of products becomes another problem because the manufacturing have to be started always after users' requests.

### Disclosure of the Invention

The present invention is accomplished in view of the aforementioned problems, and its object is to provide a method for cleaning an SOI wafer that sufficiently reduces impurity etc. adhered to the surface of the SOI wafer with inhibiting a decrease of film thickness and deterioration of haze level of the SOI layer of the SOI wafer as much as possible.

In order to achieve the aforementioned object, according to the present invention, there is provided a method for cleaning an SOI wafer having a silicon thin film on an insulator, wherein the SOI wafer is subjected to two-fluid cleaning in which two or more fluids are mixed and used for cleaning the wafer.

In this way, cleaning an SOI wafer by the two-fluid cleaning makes it possible to sufficiently reduce impurity etc. adhered to the surface of the SOI wafer with inhibiting a decrease of film thickness and deterioration of haze level of the SOI layer as much as possible.

Furthermore, a cleaned and stored SOI wafer is preferably cleaned again by the method for cleaning mentioned above.

In this way, cleaning again by the two-fluid cleaning a cleaned SOI wafer that is stored as stock makes it possible to sufficiently reduce impurity etc. adhered to the surface of the SOI wafer during storage while the cleaning does not make the SOI layer be out of spec by excessively eroding the SOI layer having film thickness in spec by etching, and the cleaning does not excessively deteriorate haze level of the SOI layer by etching. Thus the wafers can be delivered swiftly.

In the above cases, ozone cleaning is preferably conducted prior to the two-fluid cleaning.

In this way, conducting ozone cleaning prior to the two-fluid cleaning makes it possible to easily break away organic substances adhered to the surface of an SOI wafer.

In this case, ozone water used in the ozone cleaning preferably has a temperature of 50 degrees C or higher.

In this way, use of ozone water having a temperature of 50 degrees C or higher in the ozone cleaning makes it possible to enhance detergency, thereby further reducing organic substances or particles etc. adhered to the surface of an SOI wafer.

Furthermore, after the two-fluid cleaning is conducted, chemical cleaning is preferably conducted so that an etching removal of the chemical cleaning becomes 1.0 nm or less.

In this way, after the two-fluid cleaning is conducted, chemical cleaning is conducted so that an etching removal of the chemical cleaning becomes 1.0 nm or less, thereby further reducing particles on the surface of the wafer with inhibiting a decrease of film thickness and deterioration of haze level of the SOI layer as much as possible.

In addition, chemical cleaning is preferably conducted as the two-fluid cleaning so that an etching removal of the chemical cleaning becomes 1.0 nm or less by mixing at least one cleaning solution having an etching action as the fluid.

In this way, conducting chemical cleaning as the two-fluid cleaning so that an etching removal of the chemical cleaning becomes 1.0 nm or less by mixing at least one cleaning solution having an etching action as the fluid makes it possible to conduct simultaneously mechanical cleaning with impressing mechanical force and chemical cleaning to reduce particles on the surface of the wafer with inhibiting a decrease of film thickness and deterioration of haze level of the SOI layer as much as possible.

Furthermore, it is preferable that first chemical cleaning is conducted as the two-fluid cleaning by mixing at least one cleaning solution having an etching action as the fluid; and after the two-fluid cleaning, second chemical cleaning is conducted so that a total etching removal of the first chemical cleaning and the second chemical cleaning becomes 1.0 nm or less.

In this way, first chemical cleaning is conducted as the two-fluid cleaning by mixing at least one cleaning solution having an etching action as the fluid; and after the two-fluid cleaning, second chemical cleaning is conducted so that a total etching removal of the first chemical cleaning and the second chemical cleaning becomes 1.0 nm or less. That is, mechanical cleaning with impressing mechanical force and the first chemical cleaning are simultaneously conducted, and then the second chemical cleaning is conducted, thereby reducing particles on the surface of the wafer with inhibiting a decrease of film thickness and deterioration of haze level of the SOI layer as much as possible.

In the above cases, the chemical cleaning is preferably conducted by using a mixed aqueous solution of aqueous ammonia, aqueous hydrogen peroxide, and water.

In this way, the chemical cleaning is conducted by using a mixed aqueous solution of aqueous ammonia, aqueous hydrogen peroxide, and water, whereby a desired etching removal is certainly achieved, and particles on the surface of the wafer are further reduced.

As described above, in the present invention, an SOI wafer is subjected to two-fluid cleaning, whereby impurity etc. adhered to the surface of the SOI wafer can be sufficiently reduced with inhibiting a decrease of film thickness and deterioration of haze level of the SOI layer of the SOI wafer as much as possible.

### Brief Explanation of the Drawings

Fig.1 is a flow diagram schematically explaining an example of a method for manufacturing an SOI wafer according to the present invention.
Fig.2 is an example of a cleaning apparatus used for cleaning an SOI wafer according to the present invention.

### Best Mode for Carrying out the Invention

Hereinafter, an embodiment of the present invention will be explained. However, the present invention is not limited thereto.

For cleaning an SOI wafer, as with a normal silicon wafer, RCA cleaning having an etching action is generally used. In using the RCA cleaning, in order to remove particles, it is recognized that about 4 nm or more of the SOI layer have to be etched by the RCA cleaning (For example, see Cleaning and analysis of silicon wafers, p.55 to p.58, issued by Realize Limited). However, as for an SOI layer of an SOI wafer, a thinner film has been increasingly used in recent years. And subjecting an SOI wafer having an SOI layer with a thickness of 100 nm or less, particularly with a thickness of the order of several tens of nm (for example, 30 nm or less) to such RCA cleaning causes a problem that the SOI layer film thickness becomes out of spec or haze level of the SOI layer is deteriorated. Then the present inventor has thoroughly investigated, and has found that cleaning an SOI wafer by two-fluid cleaning makes it possible to sufficiently reduce impurity etc. adhered to the surface of the SOI wafer with inhibiting a decrease of film thickness and deterioration of haze level of the SOI layer of the SOI wafer as much as possible. And thus the present invention has been accomplished.

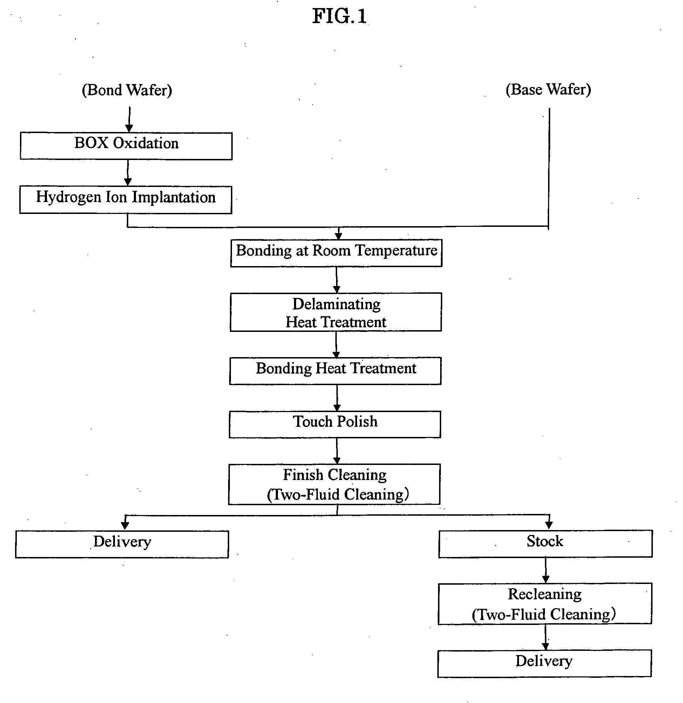

Hereinafter, such a method for cleaning an SOI wafer according to the present invention will be explained by using an example in which the method is used for manufacturing an SOI wafer by the hydrogen ion delamination method with referring to Fig.1.

First, a base wafer to be a support of an SOI wafer, and a bond wafer to be an SOI layer are prepared. Each wafer may be a mirror-polished silicon single crystal wafer. At least one of the wafers, in this explanation, the bond wafer is subjected to thermal oxidation (BOX oxidation) to form on its surface an oxide film with a thickness of about 0.02 to 2.0 µm which becomes a buried oxide film later. To the surface of the bond wafer are implanted ions of hydrogen or a rare gas to form a micro bubble layer (an enclosed layer) in parallel with the surface at an average implanted depth of the ions (This explanation will be given in the case of implanting hydrogen ions). The implantation is preferably conducted at a temperature of 25 to 450 degrees C. Adjusting implantation energy at this time makes it possible to provide the delaminated SOI layer with a desired thickness.

The hydrogen-ion implanted bond wafer is brought into contact with the base wafer by superposing the hydrogen-ion implanted surface of the bond wafer on the base wafer via the oxide film. In this step, the wafers are bonded with each other without using bonding agents etc. by bringing the surfaces of the wafers into contact with each other at room temperature in a clean atmosphere (room temperature bonding).

Then heat treatment (delaminating heat treatment) is conducted at temperature of about 500 degrees C or higher in an inert gas atmosphere, thereby delaminating the bond wafer at the enclosed layer due to crystal rearrangement and bubble agglomeration. As a result, an SOI wafer (an SOI layer + a buried oxide film + the base wafer) is obtained. Thickness of the SOI layer at this time may be 70 nm to 250 nm though the thickness is determined in accordance with spec.

The SOI wafer is subjected to high temperature heat treatment as bonding heat treatment to increase bonding strength between the wafers that is bonded by the room temperature bonding step and the delaminating heat treatment step because the bonding strength is weak for being used directly in device process. The bonding heat treatment is preferably conducted, for example, in an inert gas atmosphere at 1050 to 1200 degrees C for 30 minutes to 2 hours. Incidentally, the delaminating heat treatment and the bonding heat treatment may be conducted successively, or the delaminating heat treatment and the bonding heat treatment may be conducted as one heat treatment simultaneously.

Next, mirror-polishing with an extremely small etching removal (for example an etching removal of 150 nm or less), which is referred to as touch polish, is conducted with a polishing agent, thereby removing a crystal defect layer existing at cleavage plane, which is the surface of the SOI layer, and reducing surface roughness.

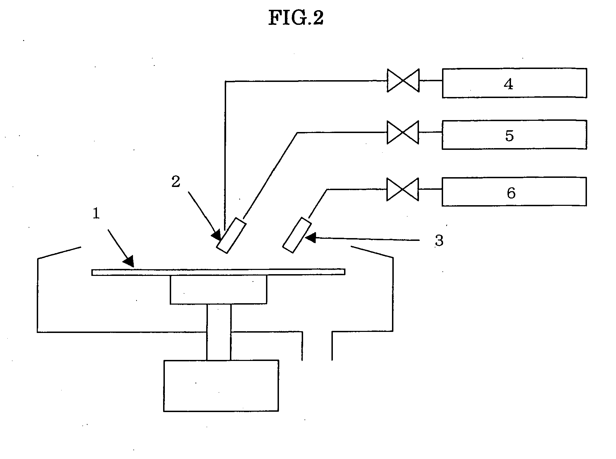

After that, as finish cleaning, the SOI wafer is subjected to two-fluid cleaning. In Fig.2, there is shown an example of a cleaning apparatus used for the finish cleaning. By using this apparatus, two or more fluids are mixed and the mixed fluid is jetted to the surface of a wafer to remove impurity. For example, ultra pure water 5 to which carbon dioxide (CO₂) is added; and nitrogen gas (N₂) 4 are mixed in a two-fluid cleaning nozzle 2, and jetted to the surface of a spinning SOI wafer 1 with scanning the nozzle in the radial direction of the wafer. In this way, use of the carbon-dioxide-added ultra pure water as a cleaning solution inhibits static electricity that is generated by friction between the surface to be treated of the semiconductor wafer and the cleaning solution. The gas preferably used in gaseous form is nitrogen gas (N₂), which is an inert gas, but other gases like air or argon (Ar) may also be used.

The present invention is characterized in that an SOI wafer is cleaned by two-fluid cleaning as described above, thereby sufficiently reducing impurity etc. adhered to the surface of the SOI wafer with inhibiting a decrease of film thickness and deterioration of haze level of the SOI layer of the SOI wafer as much as possible.

In this case, ozone cleaning may be conducted prior to the two-fluid cleaning. The ozone cleaning is effective also for removing organic substances. In the ozone cleaning, pure water 6 containing ozone of several tens of ppm is jetted from a nozzle 3 to a spinning wafer 1. At this time, the nozzle 3 is scanned in the radial direction of the wafer. In this way, conducting the ozone cleaning makes it possible to effectively remove contaminants such as organic substances adhered to the surface of the wafer. In addition, ozone water used at this time preferably has a temperature of 50 degrees C or higher because this enhances detergency, thereby removing contaminants more effectively.

Furthermore, after the two-fluid cleaning is conducted, chemical cleaning is preferably conducted so that an etching removal of the chemical cleaning becomes 1.0 nm or less. The chemical cleaning means to chemically dissolve, decompose, and remove particles, organic substances, a polishing agent, metallic impurity, etc. In this way, chemical cleaning is conducted so that an etching removal of the chemical cleaning becomes 1.0 nm or less, whereby particles on the surface of the wafer are further reduced with inhibiting a decrease of film thickness and deterioration of haze level of the SOI layer as much as possible. In this case, when the etching removal is greater than 1.0 nm, the SOI layer is excessively etched. This causes a problem that the SOI layer thickness becomes out of spec or haze level of the SOI layer is deteriorated.

As a cleaning solution used in the chemical cleaning, a mixed aqueous solution of aqueous ammonia, aqueous hydrogen peroxide, and water is preferably used. When such a cleaning solution is used, a desired etching removal is certainly achieved, and particles on the surface of the wafer are further reduced.

As for the cleaning solution, its composition ratio is not particularly restricted, but a solution containing ammonia, hydrogen peroxide, and water in the composition ratios of 1 : 1 : 10 to 200 is preferably used in contrast to a solution of 1 : 1 : 5 to 7 used in the standard SC-1 cleaning in the RCA cleaning.

SOI wafers are immersed in a cleaning solution bath filled with the cleaning solution, thereby conducting cleaning with a mixed aqueous solution of aqueous ammonia, aqueous hydrogen peroxide, and water. At this time, its cleaning time is adjusted so that the etching removal becomes 1.0 nm or less.

In the way mentioned above, the finish cleaning is conducted.

Incidentally, in the above cleaning step, the case of conducting the two-fluid cleaning and the chemical cleaning separately is explained. However, as the two-fluid cleaning, chemical cleaning may be conducted so that an etching removal of the chemical cleaning becomes 1.0 nm or less by mixing at least one cleaning solution having an etching action as the fluid. For example, in the two-fluid cleaning, use of a cleaning solution having an etching action instead of ultra pure water makes it possible to conduct chemical cleaning in which an etching removal of the chemical cleaning becomes 1.0 nm or less. The cleaning solution to be used in this case is not particularly restricted, but a mixed aqueous solution of aqueous ammonia, aqueous hydrogen peroxide, and water may be used, and its composition ratios of ammonia, hydrogen peroxide, and water are preferably 1 : 1 : 10 to 200.

Furthermore, as the two-fluid cleaning in the cleaning step, first chemical cleaning may be conducted by mixing at least one cleaning solution having an etching action as the fluid; and after the two-fluid cleaning, second chemical cleaning is conducted so that a total etching removal of the first chemical cleaning and the second chemical cleaning becomes 1.0 nm or less. For example, in the two-fluid cleaning, a cleaning solution having an etching action is used instead of ultra pure water to conduct the first chemical cleaning; and after the two-fluid cleaning, the second chemical cleaning is conducted so that a total etching removal of the first chemical cleaning and the second chemical cleaning becomes 1.0 nm or less. The cleaning solutions to be used in the first and the second chemical cleaning are not particularly restricted, but a mixed aqueous solution of aqueous ammonia, aqueous hydrogen peroxide, and water may be used, and its composition ratios of ammonia, hydrogen peroxide, and water are preferably 1 : 1 : 10 to 200.

In the way mentioned above, the finish cleaning is conducted. And then SOI wafers are contained in delivery boxes and delivered to users.

However, SOI wafers that are manufactured excessively are not delivered at once and stored as stocks. Then when a new order is received, the wafers are cleaned again and then delivered. Each of the SOI wafer stored as stocks has an SOI layer with film thickness within spec, and recleaning before delivery must not make the SOI layer out of spec by excessively decreasing film thickness of the SOI layer. Therefore, in the recleaning before delivery, the cleaning method according to the present invention is preferably used because the method sufficiently reduces impurity etc. on the surface of the SOI wafer with inhibiting a decrease of film thickness and deterioration of haze level of the SOI layer as much as possible. Specifically, in the recleaning, a method as with the finish cleaning may be used. At this time, there may be used the two-fluid cleaning, further the ozone cleaning, and the chemical cleaning to be conducted so that an etching removal of the chemical cleaning becomes 1.0 nm or less.

In this case, particularly when the recleaning is conducted to an SOI wafer with an ultra thin film, the cleaning method according to the present invention is more preferably used because it becomes especially important not to decrease the film thickness of the SOI layer. Conventional RCA cleaning, ultrasonic cleaning, brush cleaning, etc. cannot clean properly SOI wafers having an ultra thin film. Therefore, SOI wafers having an ultra thin film cannot be stored after being manufactured, and no stocks should be carried by always manufacturing the same amount of products as demanded. However, use of the cleaning method according to the present invention makes it possible to store SOI wafers having an ultra thin film after being manufactured, and deliver the wafers swiftly after the wafers are cleaned again as users demand.

Incidentally, the two-fluid cleaning according to the present invention may be used only in the recleaning step. That is, the finish cleaning in the manufacturing process of SOI wafers are conducted conventionally with RCA cleaning etc. to manufacture SOI wafers within specs, and the wafers that are stored as stocks and required to be cleaned again are subjected to the two-fluid cleaning according to the present invention. In this case, SOI wafers within spec are preferably cleaned without making the wafers out of spec. In instances where the finish cleaning is conducted with conventional RCA cleaning, for example, there may be conducted a cleaning treatment (SC-1 cleaning) at 75 to 85 degrees C for 10 to 20 minutes with a cleaning solution, which is referred to as SC-1 cleaning solution or Ammonia-Hydrogen Peroxide Mixture (APM solution), containing ammonia, hydrogen peroxide, and water in the blending volume ratio of 1 : 1 to 2 : 5 to 7; subsequently a cleaning treatment (HF cleaning) at room temperature for several tens of seconds with 1% aqueous solution of hydrofluoric acid (a diluent, Diluted Hydrofluoric acid (DHF solution)); and lastly a cleaning treatment (SC-2 cleaning) at 75 to 85 degrees C for 10 to 20 minutes with a cleaning solution, which is referred to as SC-2 cleaning solution or Hydrochloric acid-Hydrogen Peroxide Mixture (HPM solution), containing hydrochloric acid, hydrogen peroxide, and water in the blending volume ratio of 1 : 1 to 2 : 6 to 8.

In this case, because the RCA cleaning has an etching action, it is necessary to manufacture the SOI layer to be thick beforehand so that the SOI layer has thickness within spec after being subjected to RCA cleaning.

Hereinafter, Examples of the present invention will be explained. However, the present invention is not restricted thereto.

### (Example 1)

As a base wafer and a bond wafer, silicon wafers each manufactured by Czochralski method and having a diameter of 300 mm, p-type, (100) orientation, and a resistivity of 10 Ω·cm were prepared.

On the surface of the bond wafer, an oxide film with a thickness of 1.0 µm was formed. And to the surface of the bond wafer was implanted hydrogen ions to form an enclosed layer.

Then the ion implanted surface of the bond wafer was brought into contact with the base wafer at room temperature.

After that, delaminating heat treatment is conducted at 500 degrees C for 30 minutes in nitrogen gas atmosphere, thereby delaminating and thinning the bond wafer.

Subsequently, bonding heat treatment was conducted at 1100 degrees C for 2 hours in an oxidizing atmosphere to bond an SOI layer firmly.

Next, touch polish was conducted so that its stock removal became about 60 nm to polish the SOI layer.

Lastly, after rinsing was conducted, two-fluid cleaning was conducted with a cleaning apparatus shown in Fig.2. Ultra pure water 5 to which carbon dioxide (CO₂) was added was provided at 0.2 L/ min and 0.5 MPa to a nozzle 2. Nitrogen gas (N₂) 4 was provided at 235 L/ mim and 0.4 MPa to the nozzle 2. And the water 5 and the gas 4 were mixed in the nozzle 2, and this mixed fluid was jetted to the surface of an SOI wafer 1 spinning at 1800 rpm. At this time, a distance between the nozzle 2 and the wafer 1 was 20 mm, the nozzle 2 had an angle of 90°. And the nozzle 2 scanned in the radial direction of the wafer so that it takes 30 seconds per back and forth. This finish cleaning was complete, and manufacturing process of the SOI wafer was complete.

After that, film thickness was measured, and scratches or stains on the surface were inspected. The SOI layer had a film thickness of 30 nm.

### (Example 2)

As with Example 1, silicon wafers were prepared as a base wafer and a bond wafer; the bond wafer was subjected to BOX oxidation, and hydrogen ions were implanted thereto; the bond wafer and the base wafer were brought into contact each other at room temperature, and then subjected to the delaminating heat treatment, the bonding heat treatment, and the touch polish. Lastly, as a finish cleaning, ozone cleaning and two-fluid cleaning were conducted with a cleaning apparatus shown in Fig.2. In the ozone cleaning, pure water 6 containing ozone of 20 ppm was jetted at a flow rate of 1.2 L/ min from a nozzle 3 to a wafer 1 spinning at 60 rpm. At this time, the ozone water 6 had ordinary temperature, a distance between the nozzle 3 and the wafer 1 was 30 mm, the nozzle 3 had an angle of 75°. And the nozzle 3 scanned in the radial direction of the wafer so that it takes 30 seconds per back and forth. Subsequently, the two-fluid cleaning was conducted as with Example 1, and thus manufacturing process of the SOI wafer was complete.

After that, film thickness was measured, and scratches or stains on the surface were inspected. The SOI layer had a film thickness of 30 nm.

### (Example 3)

As with Example 2, silicon wafers were prepared as a base wafer and a bond wafer; the bond wafer was subjected to BOX oxidation, and hydrogen ions were implanted thereto; and the bond wafer and the base wafer were brought into contact each other at room temperature, and then subjected to the delaminating heat treatment, the bonding heat treatment, and the touch polish. Lastly, as a finish cleaning, ozone cleaning and two-fluid cleaning were conducted as with Example 2 except that ozone water used in the ozone cleaning had a temperature of 40 degrees C. And thus manufacturing process of the SOI wafer was complete.

After that, film thickness was measured, and scratches or stains on the surface were inspected. The SOI layer had a film thickness of 30 nm.

### (Example 4)

As with Example 2, silicon wafers were prepared as a base wafer and a bond wafer; the bond wafer was subjected to BOX oxidation, and hydrogen ions were implanted thereto; and the bond wafer and the base wafer were brought into contact each other at room temperature, and then subjected to the delaminating heat treatment, the bonding heat treatment, and the touch polish. Lastly, as a finish cleaning, ozone cleaning and two-fluid cleaning were conducted as with Example 2 except that ozone water used in the ozone cleaning had a temperature of 50 degrees C. And thus manufacturing process of the SOI wafer was complete.

After that, film thickness was measured, and scratches or stains on the surface were inspected. The SOI layer had a film thickness of 30 nm.

### (Example 5)

As with Example 4, silicon wafers were prepared as a base wafer and a bond wafer; the bond wafer was subjected to BOX oxidation, and hydrogen ions were implanted thereto; and the bond wafer and the base wafer were brought into contact each other at room temperature, and then subjected to the delaminating heat treatment, the bonding heat treatment, and the touch polish. Lastly, as a finish cleaning, ozone cleaning and two-fluid cleaning were conducted as with Example 4, and then chemical cleaning was conducted by using a mixed aqueous solution of aqueous ammonia, aqueous hydrogen peroxide, and water. In the chemical cleaning, a water bath was filled with a cleaning solution containing ammonia, hydrogen peroxide, and water in the composition ratios of 1 : 1 : 100, and the wafer was immersed in the bath. At this time, its etching removal was adjusted to be 0.2 nm. And thus manufacturing process of the SOI wafer was complete.

After that, film thickness was measured, and scratches or stains on the surface were inspected. The SOI layer had a film thickness of 29.8 nm.

### (Example 6)

As with Example 5, silicon wafers were prepared as a base wafer and a bond wafer; the bond wafer was subjected to BOX oxidation, and hydrogen ions were implanted thereto; and the bond wafer and the base wafer were brought into contact each other at room temperature, and then subjected to the delaminating heat treatment, the bonding heat treatment, and the touch polish. Lastly, as a finish cleaning, ozone cleaning, two-fluid cleaning and the chemical cleaning were conducted as with Example 5 except that the etching removal of the chemical cleaning was adjusted to be 1.0 nm. And thus manufacturing process of the SOI wafer was complete.

After that, film thickness was measured, and scratches or stains on the surface were inspected. The SOI layer had a film thickness of 29 nm.

### (Example 7)

As with Example 1, silicon wafers were prepared as a base wafer and a bond wafer; the bond wafer was subjected to BOX oxidation, and hydrogen ions were implanted thereto; and the bond wafer and the base wafer were brought into contact each other at room temperature, and then subjected to the delaminating heat treatment, the bonding heat treatment, and the touch polish. Lastly, as a finish cleaning, two-fluid cleaning and subsequently chemical cleaning were conducted. The two-fluid cleaning was conducted as with Example 1. And then the chemical cleaning was conducted by using a mixed aqueous solution of aqueous ammonia, aqueous hydrogen peroxide, and water. In the chemical cleaning, a water bath was filled with a cleaning solution containing ammonia, hydrogen peroxide, and water in the composition ratios of 1 : 1 : 100, and the wafer was immersed in the bath. At this time, its etching removal was adjusted to be 0.2 nm. And thus manufacturing process of the SOI wafer was complete.

After that, film thickness was measured, and scratches or stains on the surface were inspected. The SOI layer had a film thickness of 29.8 nm.

### (Example 8)

As with Example 7, silicon wafers were prepared as a base wafer and a bond wafer; the bond wafer was subjected to BOX oxidation, and hydrogen ions were implanted thereto; and the bond wafer and the base wafer were brought into contact each other at room temperature, and then subjected to the delaminating heat treatment, the bonding heat treatment, and the touch polish. Lastly, as a finish cleaning, two-fluid cleaning and chemical cleaning were conducted as with Example 7 except that the etching removal of the chemical cleaning was adjusted to be 1.0 nm. And thus manufacturing process of the SOI wafer was complete.

After that, film thickness was measured, and scratches or stains on the surface were inspected. The SOI layer had a film thickness of 29 nm.

### (Example 9)

As with Example 1, silicon wafers were prepared as a base wafer and a bond wafer; the bond wafer was subjected to BOX oxidation, and hydrogen ions were implanted thereto; and the bond wafer and the base wafer were brought into contact each other at room temperature, and then subjected to the delaminating heat treatment, the bonding heat treatment, and the touch polish. Lastly, as a finish cleaning, two-fluid cleaning were conducted. In the two-fluid cleaning, chemical cleaning was conducted by using a cleaning solution containing aqueous ammonia, aqueous hydrogen peroxide, and water in the composition ratios of 1 : 1 : 100 instead of ultra pure water in Example 1. At this time, its etching removal was adjusted to be 0.2 nm. And thus manufacturing process of the SOI wafer was complete.

After that, film thickness was measured, and scratches or stains on the surface were inspected. The SOI layer had a film thickness of 29.8 nm.

### (Example 10)

As with Example 9, silicon wafers were prepared as a base wafer and a bond wafer; the bond wafer was subjected to BOX oxidation, and hydrogen ions were implanted thereto; and the bond wafer and the base wafer were brought into contact each other at room temperature, and then subjected to the delaminating heat treatment, the bonding heat treatment, and the touch polish. Lastly, as a finish cleaning, two-fluid cleaning (chemical cleaning) was conducted as with Example 9 except that the etching removal of the chemical cleaning was adjusted to be 1.0 nm. And thus manufacturing process of the SOI wafer was complete.

After that, film thickness was measured, and scratches or stains on the surface were inspected. The SOI layer had a film thickness of 29 nm.

### (Example. 11)

As with Example 1, silicon wafers were prepared as a base wafer and a bond wafer; the bond wafer was subjected to BOX oxidation, and hydrogen ions were implanted thereto; and the bond wafer and the base wafer were brought into contact each other at room temperature, and then subjected to the delaminating heat treatment, the bonding heat treatment, and the touch polish. Lastly, as a finish cleaning, two-fluid cleaning (first chemical cleaning) and second chemical cleaning were conducted. In the two-fluid cleaning, two-fluid cleaning (first chemical cleaning) was conducted as with Example 1 except that a cleaning solution containing aqueous ammonia, aqueous hydrogen peroxide, and water in the composition ratios of 1 : 1 : 100 was used instead of ultra pure water. After that, as the second chemical cleaning, a water bath was filled with a cleaning solution containing ammonia, hydrogen peroxide, and water in the composition ratios of 1 : 1 : 100, and the wafer was immersed in the bath. At this time, a total etching removal of the first chemical cleaning and the second chemical cleaning was adjusted to becomes 0.2 nm. And thus manufacturing process of the SOI wafer was complete.

After that, film thickness was measured, and scratches or stains on the surface were inspected. The SOI layer had a film thickness of 29.8 nm.

### (Example 12)

As with Example 11, silicon wafers were prepared as a base wafer and a bond wafer; the bond wafer was subjected to BOX oxidation, and hydrogen ions were implanted thereto; and the bond wafer and the base wafer were brought into contact each other at room temperature, and then subjected to the delaminating heat treatment, the bonding heat treatment, and the touch polish. Lastly, as a finish cleaning, two-fluid cleaning (first chemical cleaning) and second chemical cleaning were conducted as with Example 12 except that the total etching removal was adjusted to become 1.0 nm. And thus manufacturing process of the SOI wafer was complete.

After that, film thickness was measured, and scratches or stains on the surface were inspected. The SOI layer had a film thickness of 29 nm.

### (Example 13)

After the SOI wafer manufactured in Example 1 was stored as stocks for 6 months, the wafer was cleaned again by conducting two-fluid cleaning with a cleaning apparatus shown in Fig.2. Ultra pure water 5 to which carbon dioxide (CO₂) was added was provided at 0.2 L/ min and 0.5 MPa to a nozzle 2. Nitrogen gas (N₂) 4 was provided at 235 L/ mim and 0.4 MPa to the nozzle 2. And thus the water 5 and the gas 4 were mixed in the nozzle 2, and this mixed fluid was jetted to the surface of a wafer 1 spinning at 1800 rpm. At this time, a distance between the nozzle 2 and the wafer 1 was 20 mm, the nozzle 2 had an angle of 90°. And the nozzle 2 scanned in the radial direction of the wafer so that it takes 30 seconds per back and forth.

After that, film thickness was measured, and scratches or stains on the surface were inspected. The film thickness of the SOI layer remained the same.

### (Example 14)

After the SOI wafer manufactured in Example 2 was stored as stocks for 6 months, the wafer was cleaned again by conducting ozone cleaning and two-fluid cleaning with a cleaning apparatus shown in Fig.2. In the ozone cleaning, pure water 6 containing ozone of 20 ppm was jetted at a flow rate of 1.2 L/ min from a nozzle 3 to a wafer 1 spinning at 60 rpm. At this time, the ozone water 6 had ordinary temperature, a distance between the nozzle 3 and the wafer 1 was 30 mm, and the nozzle 3 had an angle of 75°. And the nozzle 3 scanned in the radial direction of the wafer so that it takes 30 seconds per back and forth. Subsequently, the two-fluid cleaning was conducted as with Example 13.

After that, film thickness was measured, and scratches or stains on the surface were inspected. The film thickness of the SOI layer remained the same.

### (Example 15)

After the SOI wafer manufactured in Example 3 was stored as stocks for 6 months, the wafer was cleaned again by conducting ozone cleaning and two-fluid cleaning as with Example 14 except that ozone water used in the ozone cleaning had a temperature of 40 degrees C.

After that, film thickness was measured, and scratches or stains on the surface were inspected. The film thickness of the SOI layer remained the same.

### (Example 16)

After the SOI wafer manufactured in Example 4 was stored as stocks for 6 months, the wafer was cleaned again by conducting ozone cleaning and two-fluid cleaning as with Example 14 except that ozone water used in the ozone cleaning had a temperature of 50 degrees C.

After that, film thickness was measured, and scratches or stains on the surface were inspected. The film thickness of the SOI layer remained the same.

### (Example 17)

After the SOI wafer manufactured in Example 5 was stored as stocks for 6 months, the wafer was cleaned again by conducting ozone cleaning, two-fluid cleaning as with Example 16, and subsequently chemical cleaning by using a mixed aqueous solution of aqueous ammonia, aqueous hydrogen peroxide, and water. In the chemical cleaning, a water bath was filled with a cleaning solution containing ammonia, hydrogen peroxide, and water in the composition ratios of 1 : 1 : 100, and the wafer was immersed in the bath. At this time, its etching removal was adjusted to be 0.2 nm.

After that, film thickness was measured, and scratches or stains on the surface were inspected. The film thickness of the SOI layer changed by - 0.2 nm.

### (Example 18)

After the SOI wafer manufactured in Example 6 was stored as stocks for 6 months, the wafer was cleaned again by conducting ozone cleaning, two-fluid cleaning and chemical cleaning as with Example 17 except that the etching removal of the chemical cleaning was adjusted to be 1.0 nm.

After that, film thickness was measured, and scratches or stains on the surface were inspected. The film thickness of the SOI layer changed by - 1.0 nm.

### (Example 19)

After the SOI wafer manufactured in Example 7 was stored as stocks for 6 months, the wafer was cleaned again by conducting two-fluid cleaning as with Example 13, and subsequently chemical cleaning by using a mixed aqueous solution of aqueous ammonia, aqueous hydrogen peroxide, and water. In the chemical cleaning, a water bath was filled with a cleaning solution containing ammonia, hydrogen peroxide, and water in the composition ratios of 1 : 1 : 100, and the wafer was immersed in the bath. At this time, its etching removal was adjusted to be 0.2 nm.

After that, film thickness was measured, and scratches or stains on the surface were inspected. The film thickness of the SOI layer changed by - 0.2 nm.

### (Example 20)

After the SOI wafer manufactured in Example 8 was stored as stocks for 6 months, the wafer was cleaned again by conducting two-fluid cleaning and chemical cleaning as with Example 19 except that the etching removal of the chemical cleaning was adjusted to be 1.0 nm.

After that, film thickness was measured, and scratches or stains on the surface were inspected. The film thickness of the SOI layer changed by - 1.0 nm.

### (Example 21)

After the SOI wafer manufactured in Example 9 was stored as stocks for 6 months, the wafer was cleaned again by conducting two-fluid cleaning (chemical cleaning). In the two-fluid cleaning, two-fluid cleaning (chemical cleaning) was conducted by using a cleaning solution containing aqueous ammonia, aqueous hydrogen peroxide, and water in the composition ratios of 1 : 1 : 100 instead of ultra pure water in Example 13. At this time, its etching removal was adjusted to be 0.2 nm.

After that, film thickness was measured, and scratches or stains on the surface were inspected. The film thickness of the SOI layer changed by - 0.2 nm.

### (Example 22)

After the SOI wafer manufactured in Example 10 was stored as stocks for 6 months, the wafer was cleaned again by conducting two-fluid cleaning (chemical cleaning) as with Example 21 except that the etching removal of the chemical cleaning was adjusted to be 1.0 nm.

After that, film thickness was measured, and scratches or stains on the surface were inspected. The film thickness of the SOI layer changed by - 1.0 nm.

### (Example 23)

After the SOI wafer manufactured in Example 11 was stored as stocks for 6 months, the wafer was cleaned again by conducting two-fluid cleaning (first chemical cleaning) and second chemical cleaning. In the two-fluid cleaning, two-fluid cleaning (first chemical cleaning) was conducted as with Example 13 except that a cleaning solution containing aqueous ammonia, aqueous hydrogen peroxide, and water in the composition ratios of 1 : 1 : 100 was used instead of ultra pure water. After that, as the second chemical cleaning, a water bath was filled with a cleaning solution containing ammonia, hydrogen peroxide, and water in the composition ratios of 1 : 1 : 100, and the wafer was immersed in the bath. At this time, a total etching removal of the first chemical cleaning and the second chemical cleaning was adjusted to be 0.2 nm.

After that, film thickness was measured, and scratches or stains on the surface were inspected. The film thickness of the SOI layer changed by - 0.2 nm.

### (Example 24)

After the SOI wafer manufactured in Example 12 was stored as stocks for 6 months, the wafer was cleaned again by conducting two-fluid cleaning (first chemical cleaning) and second chemical cleaning except that the total etching removal was adjusted to be 1.0 nm.

After that, film thickness was measured, and scratches or stains on the surface were inspected. The film thickness of the SOI layer changed by - 1.0 nm.

### (Comparative Example 1)

The SOI wafer obtained in Example 4 was used as a sample. This wafer was stored as stocks for 6 months, and then cleaned again by the following RCA cleaning: the wafer was cleaned with SC-1 cleaning solution containing ammonia, hydrogen peroxide, and water in the blending volume ratio of 1 : 1 : 5 at 75 degrees C for 10 minutes; subsequently cleaned with 1% aqueous solution of hydrofluoric acid at room temperature for 20 seconds; and lastly cleaned with SC-2 cleaning solution containing hydrochloric acid, hydrogen peroxide, and water in the blending volume ratio of 1 : 1 : 6 at 75 degrees C for 10 minutes.

After that, film thickness was measured, and scratches or stains on the surface were inspected. The film thickness of the SOI layer changed by - 4.0 nm.

### (Comparative Example 2)

The SOI wafer obtained in Example 4 was used as a sample. The wafer was stored as stocks for 6 months, and then cleaned again by ultrasonic cleaning with pure water.

After that, film thickness was measured, and scratches or stains on the surface were inspected. The film thickness of the SOI layer remained the same.

### (Comparative Example 3)

The SOI wafer obtained in Example 4 was used as a sample. The wafer was stored as stocks for 6 months, and then cleaned again by brush cleaning with pure water.

After that, film thickness was measured, and scratches or stains on the surface were inspected. The film thickness of the SOI layer remained the same.

### (Evaluation Method)

The film thickness of the SOI layer of each SOI wafer obtained in the Examples and Comparative Examples was measured with an optical film thickness measurement system (trade name: NanoSpec manufactured by Nanometrics Incorporated). In addition, haze level and particle counts were measured with a surface inspection system (trade name: SP1) in DWO mode manufactured by KLA-Tencor Corporation. Thus obtained results are shown in Table 1 and 2.

**[Table 1]**

| | Cleaning Method of Finish Cleaning | Film Thickness of SOI Layer (nm) | Haze (ppb) | Count of Particles 65 nm or larger (count/300φ wafer) |
|---|---|---|---|---|
| Example 1 | Two-Fluid Cleaning | 30 | 3 | 22 |
| Example 2 | Ozone Cleaning | 30 | 3 | 18 |
| | (Ozone Water: Ordinary Temperature) | | | |
| | Two-Fluid Cleaning | | | |
| Example 3 | Ozone Cleaning | 30 | 3 | 15 |
| | (Ozone Water: 40 degrees C) | | | |
| | Two-Fluid Cleaning | | | |
| Example 4 | Ozone Cleaning | 30 | 3 | 12 |
| | (Ozone Water: 50 degrees C) | | | |
| | Two-Fluid Cleaning | | | |
| Example 5 | Ozone Cleaning | 29.8 | 5 | 8 |
| | (Ozone Water: 50 degrees C) | | | |
| | Two-Fluid Cleaning | | | |
| | Chemical Cleaning | | | |
| | (Etching Removal: 0.2 nm) | | | |
| Example 6 | Ozone Cleaning | 29 | 7 | 5 |
| | (Ozone Water: 50 degrees C) | | | |
| | Two-Fluid Cleaning | | | |
| | Chemical Cleaning | | | |
| | (Etching Removal: 1.0 nm) | | | |
| Example 7 | Two-Fluid Cleaning | 29.8 | 3 | 7 |
| | Chemical Cleaning | | | |
| | (Etching Removal: 0.2 nm) | | | |
| Example 8 | Two-Fluid Cleaning | 29 | 5 | 5 |
| | Chemical Cleaning | | | |
| | (Etching Removal: 1.0 nm) | | | |
| Example 9 | Two-Fluid Cleaning (Chemical Cleaning) | 29.8 | 3 | 8 |
| | (Etching Removal: 0.2 nm) | | | |
| Example 10 | Two-Fluid Cleaning (Chemical Cleaning) | 29 | 5 | 5 |
| | (Etching Removal: 1.0 nm) | | | |
| Example 11 | Two-Fluid Cleaning (First Chemical Cleaning) | 29.8 | 3 | 8 |
| | Second Chemical Cleaning | | | |
| | (Total Etching Removal: 0.2 nm) | | | |
| Example 12 | Two-Fluid Cleaning (First Chemical Cleaning) | 29 | 5 | 6 |
| | Second Chemical Cleaning | | | |
| | (Total Etching Removal: 1.0 nm) | | | |

**[Table 2]**

| | Cleaning Method of Recleaning | Film Thickness Change of SOI Layer (nm) | Haze (ppb) | Count of Particles 65 nm or larger (count/300φ wafer) |
|---|---|---|---|---|
| Example 13 | Two-Fluid Cleaning | ±0 | 3 | 27 |
| Example 14 | Ozone Cleaning | ±0 | 3 | 22 |
| | (Ozone Water: Ordinary | | | |
| | Temperature) | | | |
| | Two-Fluid Cleaning | | | |
| Example 15 | Ozone Cleaning | ±0 | 3 | 19 |
| | (Ozone Water: 40 degrees C) | | | |
| | Two-Fluid Cleaning | | | |
| Example 16 | Ozone Cleaning | ±0 | 3 | 15 |
| | (Ozone Water: 50 degrees C) | | | |
| | Two-Fluid Cleaning | | | |
| Example 17 | Ozone Cleaning | -0.2 | 7 | 9 |
| | (Ozone Water: 50 degrees C) | | | |
| | Two-Fluid Cleaning | | | |
| | Chemical Cleaning | | | |
| | (Etching Removal: 0.2 nm) | | | |
| Example 18 | Ozone Cleaning | -1.0 | 10 | 7 |
| | (Ozone Water: 50 degrees C) | | | |
| | Two-Fluid Cleaning | | | |
| | Chemical Cleaning | | | |
| | (Etching Removal: 1.0 nm) | | | |
| Example 19 | Two-Fluid Cleaning | -0.2 | 7 | 8 |
| | Chemical Cleaning | | | |
| | (Etching Removal: 0.2 nm) | | | |
| Example 20 | Two-Fluid Cleaning | -1.0 | 10 | 6 |
| | Chemical Cleaning | | | |
| | (Etching Removal: 1.0 nm) | | | |
| Example 21 | Two-Fluid Cleaning (Chemical Cleaning) | -0.2 | 7 | 8 |
| | (Etching Removal: 0.2 nm) | | | |
| Example 22 | Two-Fluid Cleaning (Chemical Cleaning) | -1.0 | 10 | 5 |
| | (Etching Removal: 1.0 nm) | | | |
| Example 23 | Two-Fluid Cleaning (First Chemical Cleaning) | -0.2 | 7 | 7 |
| | Second Chemical Cleaning | | | |
| | (Total Etching Removal: 0.2 nm) | | | |
| Example 24 | Two-Fluid Cleaning (First Chemical Cleaning) | -1.0 | 10 | 5 |
| | Second Chemical Cleaning | | | |
| | (Total Etching Removal: 1.0 nm) | | | |
| Comparative Example 1 | RCA Cleaning | -4.0 | 30 | 10 |
| Comparative Example 2 | Ultrasonic Cleaning | ±0 | 3 | 56 |
| Comparative Example 3 | Brush Cleaning | ±0 | 4 | 67 |

From the results shown in Table 1, each of Examples 1 to 12 satisfied spec of SOI layer film thickness, and had excellent haze level and particle level.

Furthermore, from the results of Examples 1, and 2 to 4, particle level was improved in Examples 2 to 4 using the ozone cleaning in addition to the two-fluid cleaning, and thus it has been established that conducting the ozone cleaning in addition to the two-fluid cleaning effectively reduces particle level.

In addition, from the results of Examples 2 to 4, it has been established that use of ozone water having a temperature of 50 degrees C in the ozone cleaning improves particle level further.

In Examples 5 and 6, the ozone cleaning, the two-fluid cleaning and the chemical cleaning were conducted so that respective etching removal of the chemical cleaning was 0.2 nm and 1.0 nm. Examples 5 and 6 satisfied spec of SOI layer film thickness, and had excellent haze level and better particle level than Examples 1 to 4. And thus it has been established that conducting the ozone cleaning, the two-fluid cleaning and the chemical cleaning effectively reduces particles further.

In Examples 7 and 8, the two-fluid cleaning and the chemical cleaning were conducted so that each etching removal of the chemical cleaning was 0.2 nm and 1.0 nm. Examples 7 and 8 satisfied spec of SOI layer film thickness, and had excellent haze level and better particle level than Examples 1 to 4. And thus it has been established that conducting the two-fluid cleaning and the chemical cleaning effectively reduces particle level further.

In Examples 9 and 10, the two-fluid cleaning (chemical cleaning) was conducted by using a cleaning solution having an etching solution instead of ultra pure water of two-fluid cleaning so that each etching removal was 0.2 nm and 1.0 nm. Examples 9 and 10 satisfied spec of SOI layer film thickness, and had excellent haze level and better particle level than Example 1. And thus it has been established that conducting the two-fluid cleaning (chemical cleaning) effectively reduces particle level further.

In Examples 11 and 12, the two-fluid cleaning (the first chemical cleaning) was conducted by using a cleaning solution having an etching solution instead of ultra pure water of two-fluid cleaning, and then the second chemical cleaning was conducted. In Examples 11 and 12, each total etching removal of the first and the second chemical cleaning was 0.2 nm and 1.0 nm. Examples 11 and 12 satisfied spec of SOI layer film thickness, and had excellent haze level and better particle level than Example 1. And thus it has been established that conducting the two-fluid cleaning (the first chemical cleaning) and the second chemical cleaning effectively reduces particles further.

From the results of Examples 1 to 12, it has been established that conducting the method for cleaning an SOI wafer according to the present invention makes it possible to manufacture an SOI wafer that satisfies spec of SOI layer film thickness, and has excellent haze level and particle level.

In Examples 13 to 24, the SOI wafers manufactured in Example 1 to 12 were stored as stocks for 6 months, and then the wafers were cleaned again under the same conditions, respectively.

Each of Examples 13 to 24 satisfied spec of SOI layer film thickness, and had excellent haze level and particle level.

Furthermore, in each of Examples 13 to 16, its SOI layer film thickness did not decrease, its haze level did not deteriorate, and its particle level was nearly restored to its manufactured state. Furthermore, Examples 14 to 16 in which the ozone cleaning was conducted prior to the two-fluid cleaning improved particle level in comparison with Example 13 in which only the two-fluid cleaning was conducted. In addition, among Examples 14 to 16, Example 16 in which ozone water used in the ozone cleaning had a temperature of 50 degrees C improved particle level further.

Furthermore, Examples 17 and 18 in which the ozone cleaning, the two-fluid cleaning and the chemical cleaning were conducted improved particle level further with inhibiting a decrease of film thickness and deterioration of haze level of the SOI layer as much as possible.

Moreover, Examples 19 and 24 in which the two-fluid cleaning and the chemical cleaning were conducted improved particle level further with inhibiting a decrease of film thickness and deterioration of haze level of the SOI layer as much as possible.

From the results of Examples 13 to 24, also in the case of cleaning again before delivery SOI wafers that are stored as stocks, it has been established that conducting the method for cleaning an SOI wafer according to the present invention is effective and makes it possible to sufficiently reduce impurity etc. adhered to the surface of the SOI wafer with inhibiting a decrease of film thickness and deterioration of haze level of the SOI layer of the SOI wafer as much as possible.

In Comparative Example 1, the SOI wafer obtained in Example 4 was stored as stocks for 6 months, and then cleaned again by RCA cleaning. The RCA cleaning decreased the film thickness of the SOI layer by 4 nm by an etching action, and thus the layer became out of spec. Moreover, haze level became an extremely poor of 30 ppb.

In Comparative Examples 2 and 3, the ultrasonic cleaning and the brush cleaning used there did not cause decrease of film thickness and deterioration of haze level of the SOI layer because these cleanings do not have an etching action. However, detergency of the cleanings were not enough and thus particle level was poor.

As is evident from the results mentioned above, use of the cleaning method according to the present invention sufficiently reduces impurity etc. adhered to the surface of the SOI wafer with inhibiting a decrease of film thickness and deterioration of haze level of the SOI layer as much as possible.

Furthermore, because the cleaning method has such features, the cleaning method is preferably used for cleaning again before delivery SOI wafers that are stored as stocks after being manufactured.

The present invention is not limited to the embodiments described above. The above-described embodiments are mere examples, and those having substantially the same structure as technical ideas described in the appended claims and providing the similar functions and advantages are included in the scope of the present invention.

## Claims

1. A method for cleaning an SOI wafer having a silicon thin film on an insulator, wherein the SOI wafer is subjected to two-fluid cleaning in which two or more fluids are mixed and used for cleaning the wafer.

2. The method for cleaning an SOI wafer according to Claim 1, wherein a cleaned and stored SOI wafer is cleaned again by the method for cleaning according to Claim 1.

3. The method for cleaning an SOI wafer according to Claim 1 or Claim 2, wherein ozone cleaning is conducted prior to the two-fluid cleaning.

4. The method for cleaning an SOI wafer according to Claim 3, wherein ozone water used in the ozone cleaning has a temperature of 50 degrees C or higher.

5. The method for cleaning an SOI wafer according to any one of Claims 1 to 4, wherein after the two-fluid cleaning is conducted, chemical cleaning is conducted so that an etching removal of the chemical cleaning becomes 1.0 nm or less.

6. The method for cleaning an SOI wafer according to any one of Claims 1 to 4, wherein chemical cleaning is conducted as the two-fluid cleaning so that an etching removal of the chemical cleaning becomes 1.0 nm or less by mixing at least one cleaning solution having an etching action as the fluid.

7. The method for cleaning an SOI wafer according to any one of Claims 1 to 4, wherein first chemical cleaning is conducted as the two-fluid cleaning by mixing at least one cleaning solution having an etching action as the fluid; and after the two-fluid cleaning, second chemical cleaning is conducted so that a total etching removal of the first chemical cleaning and the second chemical cleaning becomes 1.0 nm or less.

8. The method for cleaning an SOI wafer according to any one of Claims 5 to 7, wherein the chemical cleaning is conducted by using a mixed aqueous solution of aqueous ammonia, aqueous hydrogen peroxide, and water.
